# EUROPÄISCHE PATENTSCHRIFT

(11) **EP 3 084 848 B1**
(45) Veröffentlichungstag und Bekanntmachung des Hinweises auf die Patenterteilung: **01.04.2020**
(21) Anmeldenummer: 14811938.1
(22) Anmeldetag: 15.12.2014
(51) Int. Cl.: H01L 33/50

(54) **KONVERSIONSELEMENT, VERFAHREN ZUR HERSTELLUNG EINES KONVERSIONSELEMENTS, OPTOELEKTRONISCHES BAUELEMENT UMFASSEND EIN KONVERSIONSELEMENT**
CONVERSION ELEMENT, METHOD FOR THE PRODUCTION OF A CONVERSION ELEMENT, OPTOELECTRONIC COMPONENT COMPRISING A CONVERSION ELEMENT
ÉLÉMENT DE CONVERSION, PROCÉDÉ DE PRODUCTION D'UN ÉLÉMENT DE CONVERSION, COMPOSANT OPTOÉLECTRONIQUE COMPRENANT UN ÉLÉMENT DE CONVERSION

(30) Priorität: 19.12.2013 DE 102013114548; 04.03.2014 DE 102014102848
(43) Veröffentlichungstag der Anmeldung: 26.10.2016
(73) Patentinhaber: OSRAM Opto Semiconductors GmbH, 93055 Regensburg (DE); OSRAM GmbH, 80807 München (DE)
(72) Erfinder: GÖÖTZ, Britta, 93051 Regensburg (DE); SINGER, Frank, 93128 Regenstauf (DE); HÜTTINGER, Roland, 86916 Kaufering (DE)
(74) Vertreter: Epping - Hermann - Fischer
(86) Internationale Anmeldenummer: PCT/EP2014/077818
(87) Internationale Veröffentlichungsnummer: WO 2015/091388

(56) Entgegenhaltungen:
- EP-A1- 1 473 347
- EP-A1- 1 473 348
- WO-A1-2007/082663
- WO-A1-2013/084921
- DE-A1-102011 078 689
- DE-A1-102011 087 614
- US-A1- 2003 080 341

## Beschreibung

Die Erfindung betrifft ein Konversionselement, ein Verfahren zur Herstellung eines Konversionselements und ein optoelektronisches Bauelement umfassend ein Konversionselement.

Optoelektronische Bauelemente wie beispielsweise lichtemittierende Dioden (LEDs) weisen häufig Konversionselemente mit einem Leuchtstoff auf. Leuchtstoffe wandeln die von einer Strahlungsquelle emittierte Strahlung in eine Strahlung mit veränderter beispielsweise längerer Wellenlänge um. Dabei entsteht neben der emittierten veränderten Strahlung Wärme. Herkömmliche Konversionselemente weisen häufig Silikon als Matrix für die Leuchtstoffe auf. Silikon weist allerdings eine unzureichende Wärmeabfuhr der durch den Leuchtstoff entstehenden Wärme auf. Dadurch entsteht ein Wärmestau in den Konversionselementen der zu einer Reduktion der Leuchtstärke und zu einer Veränderung des Farborts sowie zu einer frühzeitigen Auswahl der LED führt.

Das Dokument DE 10 2011 078 689 A1 offenbart ein Konversionselement und ein Verfahren zur Herstellung eines Konversionselements.

Aufgabe zumindest einer Ausführungsform der vorliegenden Erfindung ist es, ein Konversionselement mit verbesserten Eigenschaften gegenüber dem Stand der Technik bereitzustellen, das außerdem kostengünstig hergestellt werden kann. Eine weitere Aufgabe besteht darin, ein gegenüber dem Stand der Technik verbessertes optoelektronisches Bauelement umfassend ein Konversionselement anzugeben.

Die Aufgabe wird durch ein Konversionselement mit den Merkmalen des Anspruchs 1 durch ein Verfahren zur Herstellung eines Konversionselements mit den Merkmalen des Anspruchs 10 und durch ein optoelektronisches Bauelement mit den Merkmalen des Anspruchs 18 gelöst.

Die Erfindung ist durch die Patentansprüche 1, 10 und 18 definiert. Vorteilhafte Ausgestaltungen und Weiterbildungen sind Gegenstand der übrigen abhängigen Patentansprüche.

Im Folgenden werden Teile der Beschreibung und Zeichnungen, die sich auf Ausführungsformen oder Ausführungsbeispiele beziehen, die nicht von den Ansprüchen abgedeckt sind, nicht als Ausführungsformen beziehungsweise Ausführungsbeispiele der Erfindung präsentiert, sondern als Beispiele, die zum Verständnis der Erfindung nützlich sind.

Es wird ein Konversionselement angegeben. Das Konversionselement umfasst ein Plättchen umfassend ein anorganisches Glas und erste Konverterpartikel. Die ersten Konverterpartikel weisen eine Hülle und einen Kern auf, wobei die Hülle ein anorganisches Material umfasst und der Kern einen nitridischen oder oxynitridischen Leuchtstoff umfasst. Die ersten Konverterpartikel sind auf und/oder in dem Plättchen umfassend das anorganische Glas angeordnet.

Dass die ersten Konverterpartikel in dem Plättchen umfassend das anorganische Glas angeordnet sind, bedeutet, dass die ersten Konverterpartikel vollständig oder teilweise in dem Plättchen, also in das anorganische Glas des Plättchens eingebettet sind. Beispielsweise kann bei einer teilweisen Einbettung 20% bis 99,9% der Oberfläche der Hülle der ersten Konverterpartikel von dem anorganischen Glas des Plättchens umgeben sein oder mit diesem in direktem mechanischen Kontakt stehen.

In einer Ausführungsform ist ein Teil der ersten Konverterpartikel auf dem Plättchen und ein Teil der ersten Konverterpartikel in dem Plättchen angeordnet.

Gemäß einer Ausführungsform besteht der Kern aus einem nitridischen oder oxynitridischen Leuchtstoff, insbesondere aus nitridischen oder oxynitridischen Leuchtstoffpartikeln.

Bevorzugt besteht der Kern aus einem nitridischen Leuchtstoff oder nitridischen Leuchtstoffpartikeln.

Durch ein Konversionselement umfassend ein anorganisches Glas kann die durch die ersten Konverterpartikel entstehende Wärme in dem Konversionselement sehr gut abgeleitet werden. Dadurch entsteht ein geringer oder vernachlässigbarer Wärmestau in dem Konversionselement. Ist das Konversionselement Bestandteil eines optoelektronischen Bauelements kann so eine konstante Leuchtstärke und ein konstanter Farbort über die Länge der Betriebsdauer des optoelektronischen Bauelements garantiert werden. Somit kann einem frühzeitigen Ausfall des optoelektronischen Bauelements vorgebeugt werden und die Lebensdauer des optoelektronischen Bauelements verlängert werden.

Dass eine Schicht oder ein Element "auf" oder "über" einer anderen Schicht oder einem anderen Element angeordnet oder aufgebracht ist, kann dabei hier und im Folgenden bedeuten, dass die eine Schicht oder das eine Element unmittelbar in direktem mechanischen und/oder elektrischen Kontakt auf der anderen Schicht oder dem anderen Element angeordnet ist. Weiter kann es auch bedeuten, dass die eine Schicht oder das eine Element mittelbar auf beziehungsweise über der anderen Schicht oder dem anderen Element angeordnet ist. Dabei können dann weitere Schichten und/oder Elemente zwischen der einen oder der anderen Schicht beziehungsweise zwischen dem einen oder dem anderen Element angeordnet sein.

Das Plättchen kann aus dem anorganischen Glas oder aus dem anorganischen Glas und den ersten Konverterpartikeln bestehen.

In einer Ausführungsform weist das anorganische Glas einen Brechungsindex η_{D}(20 °C) zwischen 1,0 und 3,0, bevorzugt zwischen 1,4 und 3,0, besonders bevorzugt zwischen 1,9 und 3,0 auf.

In einer Ausführungsform weist das anorganische Glas eine Wärmeleitfähigkeit zwischen 0,5 W m⁻¹ K⁻¹ und 3,0 W m⁻¹ K⁻¹, bevorzugt zwischen 0,6 W m⁻¹ K⁻¹ und 1,5 W m⁻¹ K⁻¹, besonders bevorzugt zwischen 0,6 W m⁻¹ K⁻¹ und 0,9 W m⁻¹ K⁻¹ auf.

In einer Ausführungsform ist das anorganische Glas ein Silikatglas, ein Boratglas oder ein Phosphatglas. Das Silikatglas enthält als Hauptbestandteil SiO₂, das Boratglas enthält als Hauptbestandteil B₂O₃ und das Phosphatglas enthält als Hauptbestandteil P₂O₅. Das Silikatglas kann weitere Metalloxide wie B₂O₃, P₂O₅, Na₂O, K₂O, Bi₂O₃ und AgO enthalten, das Boratglas kann weitere Metalloxide wie SiO₂, P₂O₅, Na₂O, K₂O, Bi₂O₃ und AgO enthalten und das Phosphatglas kann weitere Metalloxide wie B₂O₃, SiO₂, Na₂O, K₂O, Bi₂O₃ und AgO enthalten. Beispielsweise handelt es sich bei dem anorganischen Glas um ein Kalk-Natron-Glas.

In einer Ausführungsform ist das anorganische Glas ein Telluritglas. Das Telluritglas enthält als Hauptbestandteil TeO₂, also beispielsweise zu mehr als 40 Gew.% oder 50 Gew.% oder 65 Gew.%. Das Telluritglas kann außerdem eines oder mehrere weitere Metalloxide wie Bi₂O₃, B₂O₃, SiO₂, K₂O, Na₂O, Nb₂O₃, Sb₂O₃ und/oder AgO enthalten oder aus solchen Metalloxiden, zusammen mit TeO₂, bestehen.

In einer Ausführungsform ist das Plättchen umfassend oder bestehend aus dem anorganischen Glas transparent. Unter "Transparenz" wird vorliegend verstanden, dass ein Material, eine Schicht oder ein Element für das gesamte sichtbare elektromagnetische Spektrum oder eines Teilspektrums davon zumindest teilweise durchlässig ist.

Nitridische und oxynitridische Leuchtstoffe sind dadurch charakterisiert, dass diese Leuchtstoffe zumindest ein N³⁻-Ion in ihrer Zusammensetzung aufweisen. Nitridische Leuchtstoffe weisen keine Sauerstoffatome in ihrer Zusammensetzung auf. Oxynitridische Leuchtstoffe weisen neben N³⁻ zumindest ein O²⁻-Ion in ihrer Zusammensetzung auf. Beispielsweise handelt es sich bei dem nitridischen Leuchtstoff um einen Leuchtstoff der Formel M₂Si₅N₈ oder MAlSiN₃ und bei dem oxynitridischen Leuchtstoff um einen Leuchtstoff der Formel MSi₂N₂O₂. M steht dabei in den genannten Formeln für ein Erdalkalimetall oder Kombinationen mehrerer Erdalkalimetalle. Beispielsweise ist M aus einer Gruppe ausgewählt, die Ba, Sr, Ca, Mg und Kombinationen daraus umfasst. In einer Ausführungsform sind die oxynitridischen und nitridischen Leuchtstoffe beispielsweise mit einer der folgenden Aktivatoren oder Kombinationen der folgenden Aktivatoren dotiert: Cer, Europium, Terbium, Praseodym, Saramium, Mangan. Die Leuchtstoffe sind bevorzugt mit Eu²⁺ dotiert. Beispielsweise handelt es sich um einen rot emittierenden nitridischen Leuchtstoff (Ca,Sr,Ba)₂Si₅N₈:Eu²⁺ oder (Sr,Ba)₂Si₅N₈:Eu²⁺.

In einer Ausführungsform handelt es sich bei dem nitridischen Leuchtstoff um einen Leuchtstoff, der rotes Licht emittiert und bei dem oxynitridischen Leuchtstoff um einen Leuchtstoff, der grünes bis orangenes Licht emittiert.

Nitridische beziehungsweise oxynitridische Leuchtstoffe zeigen eine Reaktion mit dem anorganischen Glas, was zu einer geringeren Effizienz der Leuchtstoffe führt. Es hat sich gezeigt, dass erste Konverterpartikel, die eine Hülle aus einem anorganischen Material und einen Kern aus einem nitridischen oder oxynitridischen Leuchtstoff umfassen oder daraus bestehen, unter Beibehaltung ihrer Effizienz in anorganisches Glas eingebracht werden können. Durch die Hülle umfassend oder bestehend aus dem anorganischen Material wird der nitridische oder oxynitridische Leuchtstoff, der sich im Kern der ersten Konverterpartikel befindet vor einer Reaktion mit dem anorganischen Glas geschützt. So kann die Effizienz der nitridischen oder oxynitridischen Leuchtstoffe erhalten bleiben und zusätzlich die entstehende Wärme effizient durch das anorganische Glas abgeleitet werden.

In einer Ausführungsform ist das anorganische Material der Hülle aus einer Gruppe ausgewählt, die SiO₂, TiO, TiO₂, Al₂O₃, B₂O₃, ZrO, ZrO₂, ZnO, ZnO₂, ein anorganisch-organisches Hybridmaterial, AlN, BN, TiN, Si₃N₄, ZrN, Zn₃N₂, Graphen und Kombinationen daraus umfasst. Bevorzugt ist das anorganische Material der Hülle aus einer Gruppe ausgewählt, SiO₂, TiO, B₂O₃, ZrO, ein anorganisch-organisches Hybridmaterial, AlN, TiN, Si₃N₄ und Kombinationen daraus erfasst.

Die Hülle kann aus dem anorganischen Material bestehen.

In einer Ausführungsform umfasst das anorganisch-organische Hybridmatertial Si-O-Si-Bindungen.

In einer Ausführungsform ist das anorganisch-organische Hybridmatertial durch Hydrolsye und Kondenstaion von Tetraethoxysilan und/oder Tetramethoxysilan, bevorzugt Tetraethoxysilan hergestellt. Insbesondere handelt es sich bei dem Verfahren zur Herstellung des anorganisch-organischen Hybridmaterials um ein Sol-Gel Verfahren.

Die ersten Konverterpartikel können Kerne mit unterschiedlichen nitridischen und/oder oxynitridischen Leuchtstoffen und auch unterschiedlichen Hüllen aufweisen. Beispielsweise können sich die ersten Konverterpartikel aus ersten Konverterpartikeln mit einem Kern aus einem nitridischen Leuchtstoff und ersten Konverterpartikeln mit einem Kern aus einem oxynitridischen Leuchtstoff zusammensetzen. Die ersten Konverterpartikel können gleiche oder unterschiedliche Hüllen aufweisen.

In einer Ausführungsform weist das Plättchen zwei Hauptoberflächen auf. Als erste Hauptoberfläche wird diejenige bezeichnet, der die ersten Konverterpartikel räumlich am nächsten sind und entspricht i.d.R. der Oberfläche, auf die die Konverterpartikel bei der Herstellung des Konverterelements aufgebracht wurden. Die der ersten Hauptoberfläche gegenüberliegende Hauptoberfläche wird als zweite Hauptoberfläche bezeichnet.

Gemäß einer Ausführungsform weist das Konversionselement eine Dicke zwischen 100 µm und 200 µm auf. Bevorzugt weist das Konversionselement eine Dicke zwischen 150 µm und 200 µm auf.

In einer Ausführungsform weisen die ersten Konverterpartikel einen Durchmesser zwischen 10 µm und 100 µm, bevorzugt zwischen 10 µm und 50 µm, besonders bevorzugt zwischen 10 µm und 30 µm auf. Hier und im folgenden kann es sich bei einem Durchmesser insbesondere um den D50 Durchmesser bestimmt zum Beispiel in Q0 handeln.

Die Hülle kann eine Dicke zwischen 10 nm und 50 µm, bevorzugt zwischen 100 nm und 5 µm, besonders bevorzugt aufweisen. Die Auswahl der Dicke kann je nach Herstellungsverfahren unterschiedlich ausgewählt sein. Weist die Hülle eine hohe Dichtichkeit auf, kann eine geringe Dicke gewählt werden.

In einer Ausführungsform ist über dem Plättchen eine Schutzschicht angeordnet, die ein Material umfasst, das aus einer Gruppe ausgewählt ist, die Parylen, Polysilazan, Silikon, SiO₂, TiO, TiO₂, Al₂O₃, B₂O₃, ZrO, ZrO₂, ZnO, ZnO₂, ein anorganisch-organisches Hybridmaterial, AlN, BN, TiN, Si₃N₄, ZrN, Zn₃N₂, Graphen, ein anorganisches Glas und Kombinationen daraus umfasst. Das anorganisch-organische Hybridmaterial kann wie das anorganisch-organische Hybridmaterial der Hülle ausgewählt sein. Das anorganische Glas kann aus der gleichen Gruppe ausgewählt sein wie der für das anorganische Glas des Plättchens angegebenen. Bevorzugt ist das Material aus einer Gruppe ausgewählt ist, die Parylen, Polysilazan, Silikon, SiO₂, AlN, TiN, Si₃N₄, ZrN, Graphen, ein anorganisches Glas und Kombinationen daraus umfasst. Bevorzugt ist die Schutzschicht über der ersten Hauptoberfläche des Plättchens angeordnet.

Für die Hülle der ersten Konverterpartikel und für die erste Schutzschicht können die gleichen oder unterschiedliche Materialien gewählt werden. Das Plättchen und die Schutzschicht können das gleiche anorganische Glas umfassen oder daraus bestehen.

Insbesondere ist eine Schutzschicht über dem Plättchen, bevorzugt über der ersten Hauptoberfläche des Plättchens angeordnet, wenn die ersten Konverterpartikel auf dem Plättchen angeordnet und/oder teilweise in dem Plättchen eingebettet sind. Die Schutzschicht kann die ersten Konverterpartikel vollständig überdecken.

In einer Ausführungsform sind die ersten Konverterpartikel vollständig in das anorganische Glas des Plättchens und das Material der Schutzschicht eingebettet. Die ersten Konverterpartikel sind in dieser Ausführungsform vollständig von der Schutzschicht und dem anorganischen Glas des Plättchens umgeben und weisen somit keinen Kontakt zur Umgegebungsluft auf. Insbesondere besteht ein direkter mechanischer Kontakt zwischen der Hülle der ersten Konverterpartikel und dem Material der Schutzschicht und dem anorganischen Glas des Plättchens.

In einer Ausführungsform sind die ersten Konverterpartikel vollständig in das anorganische Glas des Plättchens eingebettet. Die ersten Konverterpartikel sind in dieser Ausführungsform vollständig von dem anorganischen Glas des Plättchens umgeben und weisen somit keinen Kontakt zur Umgegebungsluft auf. Insbesondere besteht ein direkter mechanischer Kontakt zwischen der Hülle der ersten Konverterpartikel und dem anorganischen Glas des Plättchens.

In einer Ausführungsform besteht zwischen dem anorganischen Material der Hülle der ersten Konverterpartikel und dem anorganischen Glas des Plättchens eine chemische Bindung und/ oder physikalische Wechselwirkungen. Bei der chemischen Bindung kann es sich um eine ionische und/oder eine kovalente Bindung handeln.

Zwischen dem Material der Schutzschicht und dem Material der Hülle der ersten Konverterpartikel können chemische Bindungen und/oder physikalische Wechselwirkungen bestehen.

Beispielsweise handelt es sich bei den chemischen Bindungen um kovalente und/oder ionische Bindungen.

Durch die chemische Anbindung der ersten Konverterpartikel an das anorganische Glas und/oder das Material der Schutzschicht sind die ersten Konverterpartikel in dem Konversionselement fest eingebunden und unterliegen somit keiner Diffusion.

In einer Ausführungsform umfasst das Konversionselement zweite Konverterpartikel. Die zweiten Konverterpartikel sind auf und/oder in dem Plättchen umfassend das anorganische Glas angeordnet. Die zweiten Konverterpartikel können einen oxidischen Leuchtstoff umfassen oder aus einem oxidischen Leuchtstoff bestehen. Unter oxidischen Leuchtstoffen werden Leuchtstoffe verstanden, die zumindest ein O²⁻-Ion und keine N³⁻ Ionen in ihrer Zusammensetzung enthalten. Als oxidische Leuchtstoffe können Granate eingesetzt werden, beispielsweise Yttriumaluminiumgranat (YAG) oder Lutetiumaluminiumgranat (LuAG). Die oxidischen Leuchtstoffe können unter Beibehaltung ihrer Effizienz ohne Hülle in das anorganisches Glas des Plättchens ein- oder aufgebracht werden.

In einer Ausführungsform sind die zweiten Konverterpartikel vollständig in das anorganische Glas des Plättchens eingebettet. Die zweiten Konverterpartikel sind in dieser Ausführungsform vollständig von dem anorganischen Glas des Plättchens umgeben und weisen somit keinen Kontakt zur Umgegebungsluft auf. Insbesondere besteht ein direkter mechanischer Kontakt zwischen den zweiten Konverterpartikeln und dem anorganischen Glas des Plättchens.

Das Plättchen kann aus dem anorganischen Glas und den ersten und zweiten Konverterpartikeln bestehen.

Das Plättchen kann aus dem anorganischen Glas und den zweiten Konverterpartikeln bestehen. Die ersten Konverterpartikel sind dann auf dem Plättchen angeordnet.

In einer Ausführungsform umfasst das Konversionselement erste Konverterpartikel, die rotes Licht emittieren und zweite Konverterpartikel die gelbes und/oder grünes Licht emittieren.

In einer Ausführungsform ist auf dem Plättchen eine antireflektive und/oder reflektive Schicht angeordnet. Die antireflektive und/oder reflektive Schicht ist bevorzugt über der zweiten Hauptoberfläche des Plättchens angeordnet. Die antireflektive und/oder reflektive Schicht kann eine Bandpass- oder Kantenfiltercharakteristik aufweisen. Beispielsweise kann eine antireflektive und/oder reflektive Schicht für Strahlung bestimmter Wellenlängen durchlässig und für Strahlung anderer Wellenlängen reflektiv sein. Möglich ist auch eine 3D-Struktur, die eine Lichtauskopplung verbessert oder eine Richtungscharakteristik für Licht beinhaltet.

Die angegebenen Ausführungsformen des Konversionselements können gemäß einem nachfolgend genanntem Verfahren hergestellt werden. Das heißt, sämtliche für das Konversionselement angegebenen Merkmale sind auch für die hier beschriebenen Verfahren offenbart und umgekehrt.

Ein Verfahren zur Herstellung eines Konversionselements umfasst bevorzugt die folgenden Verfahrensschritte, insbesondere in der angegebenen Reihenfolge:
A) Beschichtung von Partikeln eines nitridischen oder oxynitridischen Leuchtstoffs mit einem anorganischen Material, das aus einer Gruppe ausgewählt ist, die SiO₂, TiO, TiO₂, Al₂O₃, B₂O₃, ZrO, ZrO₂, ZnO, ZnO₂, ein anorganisch-organisches Hybridmaterial, AlN, BN, TiN, Si₃N₄, ZrN, Zn₃N₂, Graphen und Kombinationen daraus umfasst. Dadurch entstehen erste Konverterpartikel, die eine Hülle aus einem anorganischen Material und einen Kern aus dem nitridischen oder oxynitridischen Leuchtstoff aufweisen;
B) Bereitstellen eines Plättchens umfassend ein anorganisches Glas;
C) Anschmelzen einer Oberflächenschicht des Plättchens;
E) Aufbringen der ersten Konverterpartikel auf die angeschmolzene Oberflächenschicht.

In einer Ausführungsform umfasst das Verfahren zur Herstellung eines Konversionselements bevorzugt die folgenden Verfahrensschritte, insbesondere in der angegebenen Reihenfolge:
A) Beschichtung von Partikeln eines nitridischen oder oxynitridischen Leuchtstoffs mit einem anorganischen Material, das aus einer Gruppe ausgewählt ist, die SiO₂, TiO, TiO₂, Al₂O₃, B₂O₃, ZrO, ZrO₂, ZnO, ZnO₂, ein anorganisch-organisches Hybridmaterial, AlN, BN, TiN, Si₃N₄, ZrN, Zn₃N₂, Graphen und Kombinationen daraus umfasst, sodass erste und/oder zweite Konverterpartikel entstehen, die eine Hülle aus einem anorganischen Material und einen Kern aus dem nitridischen oder oxynitridischen Leuchtstoff aufweisen;
B) Erzeugen einer Glasfritte oder eines Pulvers aus einem anorganischen Glas, beispielsweise aus einem weiter oben angegegebenen anorganischen Glas;
C) Mischen der Glasfritte oder des Pulvers mit den Konverterpartikeln, einem flüssigen Dispersionsmittel und einem optionalen Binder, sodass eine Grundformmasse, auch als Slurry bezeichnet, entsteht, wobei die Grundformmasse bevorzugt für ein Foliengießen, englisch Tape Casting, geeignet ist;
D) Gießen, insbesondere Foliengießen, der Grundformmasse zu einem Konversionselementerohkörper oder zu den Plättchen, insbesondere zu einer Folie, wobei das Dispersionsmittel vollständig oder zum Teil verdampft;
E) optional Zerteilen des Konversionselementerohkörpers zu den Konversionselementen, zum Beispiel mittels Sägen, Brechen, Schneiden, Hacken, Stanzen oder Laserbehandlung, wobei unmittelbar nach dem Schritt E) die Konversionselemente und/oder die Plättchen noch lateral größere Abmessungen aufweisen können als die fertig hergestellten Konversionselemente, sodass ein Schrumpfen während eines opionalen Sintervorgangs beim Zerteilen berücksichtigt wird;
F) sofern ein Binder verwendet wird, Entfernen des Binders, sodass das anorganische Glas und die Konverterpartikel, insbesondere ausschließlich das anorganische Glas und die Konverterpartikel, verbleiben;
G) Sintern der Plättchen und/oder der Konversionselemente und/oder des Konversionselementerohkörpers, sodass sich das anorganische Glas mit den Konverterpartikeln verbindet; und
H) optional Formen zu den Plättchen und/oder zu den Konversionselementen aus dem Konversionselementerohkörper oder Formen zu den Konversionselementen aus den im Schritt E erhaltenen Konversionselementen und/oder Plättchen, beispielsweise durch Sägen, Schleifen, Laserschneiden, Schneiden, Ritzen und Brechen, Wasserstrahlschneiden oder Stanzen, um die finale Form der Konversionselemente zu erhalten.

Das Sintern im Schritt G erfolgt bevorzugt bei einer Temperatur und über eine Zeitspanne hinweg, sodass ein festes, dauerhaftes und mechanisch stabiles Konversionselement und/oder Plättchen erzeugt wird, sodass insbesondere ein inniger Kontakt zwischen dem anorganischen Glas und den Konverterpartikeln hergestellt wird. Dabei sind die Temperatur und die Dauer des Sinterns aber besonders bevorzugt so gewählt, dass das anorganische Glas nicht mit den Kernen der Konverterpartikel reagiert.

Der Konversionselementerohkörper ist beispielsweise eine Keramikfolie oder ein dünnes Keramikblatt, das mehrere der Konversionselemente umfasst. Der Konversionselementerohkörper ist dazu eingerichtet, zu den Konversionselementen vereinzelt zu werden.

Neben diesen beiden beschriebenen Verfahren kann das Konversionselement auch über andere Methoden hergestellt werden.

In einer Ausführungsform umfasst das anorganisch-organische Hybridmaterial Si-O-Si-Bindungen.

In einer Ausführungsform ist das anorganisch-organische Hybridmatertial durch Hydrolsye und Kondenstaion von Tetraethoxysilan und/oder Tetramethoxysilan, bevorzugt Tetraethoxysilan hergestellt. Insbesondere handelt es sich bei dem Verfahren zur Herstellung des anorganisch-organischen Hybridmaterials um ein Sol-Gel Verfahren.

In einer Ausführungsform weist das Plättchen zwei Hauptoberflächen auf. Als erste Hauptoberfläche wird in dem hergestellten Konversionselement die Hauptoberfläche bezeichnet, der die ersten Konverterpartikel räumlich am nächsten sind. Die der ersten Hauptoberfläche gegenüberliegende Hauptoberfläche wird als zweite Hauptoberfläche bezeichnet. In Verfahrensschritt E) werden die ersten Konverterpartikel auf die erste Hauptoberfläche des Plättchens aufgebracht. Bei der Oberflächenschicht des Plättchens in Verfahrensschritt C) handelt es sich um die Oberflächenschicht der ersten Hauptoberfläche des Plättchens.

Durch dieses Verfahren ist es möglich nitridische und/oder oxynitridische Leuchtstoffe auf oder in ein Plättchen aus anorganischem Glas auf- oder einzubringen. Insbesondere kann die Effizienz der nitridischen und/oder oxynitridischen Leuchtstoffe in dem Konversionselement durch dieses Verfahren erhalten bleiben. Bislang war dies nicht möglich, da nitridische und/oder oxynitridische Leuchtstoffe beziehungsweise Leuchtstoffpartikel eine Reaktion mit dem angeschmolzenen anorganischen Glas eingehen. In dem angeschmolzenden Glas befinden sich bewegliche O²⁻-Ionen, die mit dem nitridischen und/oder oxynitridsichen Leuchtstoff reagieren. Diese unerwünschte Reaktion führt zu Effizienzverlusten der Leuchtstoffe. Durch die Beschichtung von Partikeln eines nitridischen oder oxynitridischen Leuchtstoffs mit einem anorganischen Material kann diese Reaktion vermieden werden und somit die Effizienz der Leuchtstoffe erhalten bleiben.

In einer Ausführungsform besteht das Plättchen in Verfahrensschritt B) aus dem anorganischen Glas.

In einer Ausführungsform sind zweite Konverterpartikel, die einen oxidischen Leuchtstoff umfassen oder aus einem oxidischen Leuchtstoff bestehen in dem Plättchen umfassend ein anorganisches Glas in Verfahrensschritt B) angeordnet. Das Plättchen kann aus dem anorganischen Glas und den zweiten Konverterpartikeln bestehen.

In einer Ausführungsform wird beim Aufbringen der ersten Konverterpartikel auf die angeschmolzene Oberflächenschicht in Verfahrensschritt E) die Hülle der ersten Konverterpartikel angeschmolzen, wenn diese mit der angeschmolzenen Oberflächenschicht in Kontakt kommt. Insbesondere wird dabei die Hülle nicht vollständig aufgeschmolzen. Das bedeutet, dass das anorganische Material der Hülle, das direkt an den Kern der ersten Konverterpartikel angrenzt nicht angeschmolzen wird. So kann der Kern, also der nitridische oder oxynitridische Leuchtstoff effizient vor einer Reaktion mit dem anorganischen Glas geschützt werden. Dadurch, dass das anorganische Material der Hülle, das direkt an den Kern der ersten Konverterpartikel angrenzt nicht angeschmolzen wird, können beispielsweise anorganische Materialien wie SiO₂ eingesetzt werden. Würde die Hülle vollständig angeschmolzen, bestünde bei einer Hülle aus beispielsweise SiO₂ auch die Gefahr, dass O²⁻-Ionen eine Reaktion mit dem nitridischen oder oxynitridischen Leuchtstoff eingehen.

Die Hülle kann eine Dicke zwischen 10 nm und 50 µm, bevorzugt zwischen 100 nm und 5 µm aufweisen. Bei der Wahl dieser Dicken kann sichergestellt werden, dass das anorganische Material der Hülle, das direkt an den Kern der ersten Konverterpartikel angrenzt nicht angeschmolzen wird.

In einer Ausführungsform folgt nach Verfahrensschritt E) ein weiterer Verfahrensschritt:
F) Teilweises und/oder vollständiges Einsinkenlassen der ersten Konverterpartikel in die angeschmolzene Oberflächenschicht.

Vollständiges Einsinkenlassen bedeutet, dass die ersten Konverterpartikel soweit in die angeschmolzene Oberflächenschicht einsinken, dass die komplette Oberfläche der Hülle der ersten Konverterpartikel in das angeschmolzene Glas eingebettet ist beziehungsweise mit dem angeschmolzenen Glas in direktem mechanischen Kontakt steht. Bevorzugt sinken die ersten Konverterpartikel nur soweit ein, dass die erste Hauptoberfläche des Plättchens den ersten Konverterpartikeln räumlich näher ist als die zweite Hauptoberfläche des Plättchens. Teilweises Einsinkenlassen bedeutet, dass die ersten Konverterpartikel soweit in die angeschmolzene Oberflächenschicht einsinken, dass 20% bis 99,9% der Oberfläche der Hülle der ersten Konverterpartikel in das anorganischen Glas des Plättchen eingebettet sind oder mit diesem in direktem mechanischen Kontakt stehen.

In einer Ausführungsform des Verfahrens entstehen physikalische Wechselwirkungen und/oder chemische Bindungen, insbesondere ionische und/oder kovalente Bindungen zwischen dem angeschmolzenen anorganischen Material der Hülle der ersten Konverterpartikel und dem angeschmolzenen anorganischen Glas. Die physikalischen Wechselwirkungen und/oder chemischen Bindungen entstehen nach dem Aufbringen der ersten Konverterpartikel auf die angeschmolzene Oberflächenschicht in Verfahrensschritt E) oder nach oder während dem teilweisen und/oder vollständigen Einsinkenlassen der ersten Konverterpartikel in die angeschmolzene Oberflächenschicht in Verfahrensschritt F).

In einer Ausführungsform des Verfahrens findet nach Verfahrensschritt C) ein weiterer Verfahrensschritt statt: D) Aufbringen von zweiten Konverterpartikeln, die einen oxidischen Leuchtstoff umfassen auf die angeschmolzene Oberflächenschicht. Insbesondere bestehen die zweiten Konverterpartikel aus dem oxidischen Leuchtstoff.

Im Gegensatz zu nitridischen und oxynitridischen Leuchtstoffen zeigen die oxidischen Leuchtstoffe zwar eine Wechselwirkung mit O²⁻-Ionen des angeschmolzenen anorganischen Glases, diese Wechselwirkung wirkt sich jedoch nicht, oder nur sehr geringfügig auf die Effizienz des oxidischen Leuchtstoffs aus. Da die zweiten Konverterpartikel somit unempfindlich gegenüber dem angeschmolzenen anorganischen Glas sind, werden diese bevorzugt vor den ersten Konverterpartikeln auf die angeschmolzene Oberflächenschicht aufgebracht oder aufgebracht und eingesunken. Außerdem benötigen die zweiten Konverterpartikel keine schützende Hülle.

In einer Ausführungsform des Verfahrens findet nach Verfahrensschritt D) ein weiterer Verfahrensschritt statt: D1) vollständiges Einsinkenlassen der zweiten Konverterpartikel in die angeschmolzene Oberflächenschicht.

Ist die Oberflächenschicht nach Verfahrensschritt D1) nicht mehr angeschmolzen, kann Verfahrensschritt C) erneut vor Verfahrensschritt E) stattfinden.

In einer Ausführungsform werden in Verfahrensschritt E) die ersten und zweiten Konverterpartikel gleichzeitig auf die angeschmolzene Oberflächenschicht aufgebracht. Verfahrensschritt D1) kann dann nach Verfahrensschritt E) stattfinden.

In einer Ausführungsform wird ein Schlicker oder ein Gel umfassend das anorganische Material, oder das anorganische Material in einem gasförmigen Aggregatszustand zur Beschichtung der Partikel des nitridischen oder oxynitridischen Leuchtstoffs in Verfahrensschritt A) eingesetzt. Bei einem Schlicker handelt es sich um eine Dispersion des anorganischen Materials in Wasser oder in einem Alkohol, beispielsweise Ethanol. Zusätzlich kann der Schlicker einen Binder enthalten, beispielsweise Polyvinylalkohol. Wird ein Gel umfassend das anorganische Material eingesetzt, handelt es sich beispielsweise um ein Gel, das durch ein Sol-Gel Verfahren hergestellt wird. Beispielsweise kann als Edukt in einem Sol-Gel Verfahren Tetraethoxysilan oder Tetramethoxysilan als Edukt eingesetzt werden. Durch Hydrolyse und Kondensation entsteht in dem Sol-Gel Prozess ein anorganisch-organisches Hybridmaterial, das Si-O-Si-Bindungen enthält.

Nach Verfahrensschritt E) oder F) kann ein weiterer Verfahrensschritt stattfinden:
G) Aufbringen einer Schutzschicht, die ein Material umfasst, das aus einer Gruppe ausgewählt ist, die Parylen, Polysilazan, Silikon, SiO₂, TiO, TiO₂, Al₂O₃, B₂O₃, ZrO, ZrO₂, ZnO, ZnO₂, ein anorganisch-organisches Hybridmaterial, AlN, BN, TiN, Si₃N₄, ZrN, Zn₃N₂, Graphen, ein anorganisches Glas und Kombinationen daraus umfasst auf die erste Hauptoberfläche des Plättchens. Insbesondere wird die Schutzschicht aufgebracht wenn die ersten Konverterpartikel auf dem Plättchen angeordnet sind oder in Verfahrensschritt F) nur teilweise in die angeschmolzene Oberflächenschicht eingesunken sind. Umfasst die Schutzschicht ein Material, das aus einer Gruppe ausgewählt ist, die SiO₂, TiO, TiO₂, Al₂O₃, B₂O₃, ZrO, ZrO₂, ZnO, ZnO₂, AlN, BN, TiN, Si₃N₄, ZrN, Zn₃N₂, Graphen und Kombinationen daraus umfasst, kann diese mittels eines CVD-Verfahrens (chemical vapour deposition) aufgebracht werden.

Nach Verfahrensschritt E), F) oder G) kann ein weiterer Verfahrensschritt stattfinden:
H) Aufbringen einer antireflektiven und/oder reflektiven Schicht auf die zweite Hauptoberfläche des Plättchens.

Die angegebenen Ausführungsformen des Konversionselements können in einem optoelektronischen Bauelement vorhanden sein.

Es wird weiterhin ein optoelektronisches Bauelement angegeben. Das optoelektronische Bauelement umfasst eine Schichtenfolge mit einer aktiven Schicht, die im Betrieb des Bauelements elektromagnetische Primärstrahlung emittiert. Weiter umfasst das optoelektronische Bauelement zumindest ein Konversionselement. Das Konversionselement umfasst ein Plättchen umfassend ein anorganisches Glas und erste Konverterpartikel. Die ersten Konverterpartikel weisen eine Hülle und einen Kern auf, wobei die Hülle ein anorganisches Material umfasst und der Kern einen nitridischen oder oxynitridischen Leuchtstoff umfasst. Die ersten Konverterpartikel sind auf und/oder in dem Plättchen umfassend das anorganische Glas angeordnet. Das Konversionselement ist im Strahlengang der elektromagnetischen Primärstrahlung und über der Schichtenfolge angeordnet. Die ersten Konverterpartikel konvertieren zumindest teilweise die elektromagnetische Primärstrahlung in eine elektromagnetische Sekundärstrahlung.

Ein solches optoelektronische Bauelement mit einem wie weiter oben beschriebenen Konversionselement weist eine konstante Leuchtstärke und einen konstanten Farbort über die Länge der Betriebsdauer des optoelektronischen Bauelements auf, da das anorganische Glas die durch die ersten Konverterpartikel entstehende Wärme in dem Konversionselement sehr gut ableiten kann. Somit kann einem frühzeitigen Ausfall des optoelektronischen Bauelements vorgebeugt werden und die Lebensdauer des optoelektronischen Bauelements verlängert werden.

Dass Konverterpartikel die elektromagnetische Primärstrahlung zumindest teilweise in eine elektromagnetische Sekundärstrahlung konvertieren, kann zum Einen bedeuten, dass die elektromagnetische Primärstrahlung teilweise von den Konverterpartikeln absorbiert und als Sekundärstrahlung mit einem zumindest teilweise von der Primärstrahlung verschiedenen Wellenlängenbereich emittiert wird. Ein Teil der absorbierten Primärstrahlung wird hierbei als Wärme von den Konverterpartikeln abgegeben. Die nicht absorbierte elektromagnetische Primärstrahlung kann emittiert werden.

Dass die Konverterpartikel zumindest teilweise die elektromagnetische Primärstrahlung in eine elektromagnetische Sekundärstrahlung konvertieren, kann auch bedeuten, dass die elektromagnetische Primärstrahlung nahezu vollständig durch die Konverterpartikel absorbiert wird und in Form einer elektromagnetischen Sekundärstrahlung und in Form von Wärme abgegeben wird. Die emittierte Strahlung des optoelektronischen Bauelements gemäß dieser Ausführungsform entspricht somit nahezu vollständig der elektromagnetischen Sekundärstrahlung. Unter nahezu vollständiger Konversion ist eine Konversion über 95 %, insbesondere über 98 % zu verstehen.

Unter "Schichtenfolge" ist in diesem Zusammenhang eine mehr als eine Schicht umfassende Schichtenfolge zu verstehen, beispielsweise eine Folge einer p-dotierten und einer n-dotierten Halbleiterschicht, wobei die Schichten übereinander angeordnet sind.

Die Schichtenfolge kann als Epitaxieschichtenfolge oder als strahlungsemittierender Halbleiterchip mit einer Epitaxieschichtenfolge, also als epitaktisch gewachsene Halbleiterschichtenfolge ausgeführt sein. Dabei kann die Schichtenfolge beispielsweise auf der Basis von InGaAlN ausgeführt sein. InGaAlN-basierte Halbleiterchips und Halbleiterschichtenfolgen sind insbesondere solche, bei denen die epitaktisch hergestellte Halbleiterschichtenfolge eine Schichtenfolge aus unterschiedlichen Einzelschichten aufweist, die mindestens eine Einzelschicht enthält, die ein Material aus dem III-V-Verbindungshalbleitermaterialsystem InₓAl_{y}Ga_{1-x-y}N mit 0 ≤ x ≤ 1, 0 ≤ y ≤ 1 und x + y ≤ 1 aufweist. Halbleiterschichtenfolgen, die zumindest eine aktive Schicht auf Basis von InGaAlN aufweisen, können beispielsweise elektromagnetische Strahlung in einem ultravioletten bis grünen Wellenlängenbereich emittieren.

Alternativ oder zusätzlich kann die Halbleiterschichtenfolge oder der Halbleiterchip auch auf InGaAlP basieren, das heißt, dass die Halbleiterschichtenfolge unterschiedliche Einzelschichten aufweisen kann, wovon mindestens eine Einzelschicht ein Material aus dem III-V-Verbindungshalbleitermaterialsystem InₓAl_{y}Ga_{1-x-y}P mit 0 ≤ x ≤ 1, 0 ≤ y ≤ 1 und x + y ≤ 1 aufweist. Halbleiterschichtenfolgen oder Halbleiterchips, die zumindest eine aktive Schicht auf Basis von InGaAlP aufweisen, können beispielsweise bevorzugt elektromagnetische Strahlung mit einer oder mehreren spektralen Komponenten in einen grünen bis roten Wellenlängenbereich emittieren.

Alternativ oder zusätzlich kann die Halbleiterschichtenfolge oder der Halbleiterchip auch andere III-V-Verbindungshalbleitermaterialsysteme, beispielsweise ein AlGaAs-basiertes Material, oder II-VI-Verbindungshalbleitermaterialsysteme aufweisen. Insbesondere kann eine aktive Schicht, die ein AlGaAs-basiertes Material aufweist, geeignet sein, elektromagnetische Strahlung mit einer oder mehreren spektralen Komponenten in einem roten bis infraroten Wellenlängenbereich zu emittieren.

Die aktive Halbleiterschichtenfolge kann neben der aktiven Schicht weitere funktionale Schichten und funktionelle Bereiche umfassen, etwa p- oder n-dotierte Ladungsträgertransportschichten, also Elektronen- oder Löchertransportschichten, undotierte oder p- oder n-dotierte Confinement-, Cladding- oder Wellenleiterschichten, Barriereschichten, Planarisierungsschichten, Pufferschichten, Schutzschichten und/oder Elektroden sowie Kombinationen daraus. Weiterhin können beispielsweise auf einer dem Aufwachssubstrat abgewandten Seite der Halbleiterschichtenfolge eine oder mehrere Spiegelschichten aufgebracht sein. Die hier beschriebenen Strukturen die aktive Schicht oder die weiteren funktionalen Schichten und Bereiche betreffend sind dem Fachmann insbesondere hinsichtlich Aufbau, Funktion und Struktur bekannt und werden von daher an dieser Stelle nicht näher erläutert.

In einer Ausführungsform umfasst das Konversionselement zweite Konverterpartikel. Die zweiten Konverterpartikel sind auf und/oder in dem Plättchen umfassend das anorganische Glas angeordnet. Bevorzugt sind die zweiten Konverterpartikel vollständig in das anorganische Glas des Plättchens eingebettet. Die zweiten Konverterpartikel können einen oxidischen Leuchtstoff umfassen oder aus einem oxidischen Leuchtstoff bestehen.

Sind erste und zweite Konverterpartikel in dem Konversionselement vorhanden, können die ersten Konverterpartikel räumlich näher an der ersten Hauptoberfläche angeordnet sein als die zweiten Konverterpartikel.

Sind erste und zweite Konverterpartikel in dem Konversionselement vorhanden, setzt sich die elektromagnetische Sekundärstrahlung aus der elektromagnetischen Sekundärstrahlung der ersten und der zweiten Konverterpartikel zusammen.

Bevorzugt können die Primärstrahlung und die Sekundärstrahlung überlagert einen weißfarbigen Leuchteindruck erwecken. Dazu kann die Primärstrahlung vorzugsweise einen blaufarbigen Leuchteindruck, die Sekundärstrahlung der ersten Konverterpartikel einen rotfarbigen Leuchteindruck und die Sekundärstrahlung der zweiten Konverterpartikel einen gelbfarbigen Leuchteindruck erwecken.

In einer Ausführungsform emittiert das optoelektronische Bauelement weißes Licht mit einer Farbtemperatur von 2200 K bis 5700 K.

In einer Ausführungsform ist zwischen der Schichtenfolge und dem Konversionselement eine Haftschicht angeordnet. Die Haftschicht kann beispielsweise Silikone oder Epoxidharze umfassen oder daraus bestehen. Epoxidharze werden insebsondere eingesetzt, wenn ein Licht im Nicht-Blauen Bereich emittiert wird.

Dass eine Schicht oder ein Element "zwischen" zwei anderen Schichten oder Elementen angeordnet ist, kann hier und im Folgenden bedeuten, dass die eine Schicht oder das eine Element unmittelbar in direktem mechanischen und/oder elektrischen Kontakt oder in mittelbarem Kontakt zu einer der zwei anderen Schichten oder Elementen und in direktem mechanischen und/oder elektrischen Kontakt oder elektrischen oder in mittelbarem Kontakt zu anderen der zwei anderen Schichten oder Elementen angeordnet ist. Dabei können bei mittelbarem Kontakt dann weitere Schichten und/oder Elemente zwischen der einen und zumindest einer der zwei anderen Schichten beziehungsweise zwischen dem einen und zumindest einem der zwei anderen Elemente angeordnet sein.

Sind die ersten oder die ersten und die zweiten Konverterpartikel vollständig in das Plättchen eingebettet, kann das Konversionselement so über der Schichtenfolge angeordnet sein, dass die erste oder die zweite Hauptoberfläche des Plättchen der Schichtenfolge zugewandt ist.

Sind die ersten Konverterpartikel teilweise in dem Plättchen eingebettet und/oder auf dem Plättchen angeordnet, kann das Konversionselement so über der Schichtenfolge angeordnet sein, dass die zweite Hauptoberfläche des Plättchens der Schichtenfolge zugewandt ist.

Das optoelektronische Bauelement kann ein Gehäuse umfassen. In dem Gehäuse kann in der Mitte eine Ausnehmung vorhanden sein. Die Schichtenfolge kann in der Ausnehmung angebracht sein. Die Ausnehmung kann mit einem Verguss ausgefüllt sein.

In einer Ausführungsform ist das Konversionselement über dem Verguss angeordnet. Der Verguss kann aus herkömmlichen Vergussmaterialien ausgewählt sein.

Bei dem optoelektronischen Bauelement kann es sich um Lumineszenzdioden, Photodioden-Transistoren-Arrays/Module und optische Koppler handeln. Alternativ ist es möglich eine organische Leuchtdiode als optoelektronisches Bauelement auszuwählen.

Weitere vorteilhafte Ausführungsformen und Weiterbildungen der Erfindung ergeben sich aus den im Folgenden in Verbindung mit den Figuren beschriebenen Ausführungsbeispielen.
Figuren 1a bis 2b zeigen schematische Seitenansichten verschiedener Ausführungsformen von Konversionselementen.
Figuren 3 und 4 zeigen schematische Seitenansichten verschiedener Ausführungsformen von optoelektronischen Bauelementen.

In den Ausführungsbeispielen und Figuren sind gleiche oder gleich wirkende Bestandteile jeweils mit den gleichen Bezugszeichen versehen. Die dargestellten Elemente und deren Größenverhältnisse untereinander sind nicht als maßstabsgerecht anzusehen, vielmehr können einzelne Elemente insbesondere Schichtdicken zum besseren Verständnis übertrieben groß dargestellt sein.

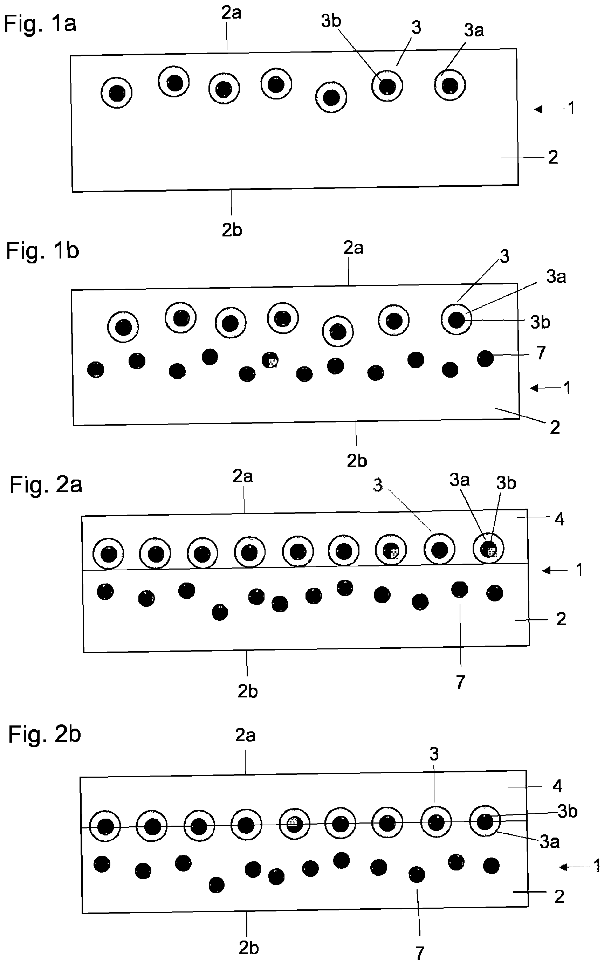

Das Konversionselement 1 gemäß Figur 1a zeigt ein Plättchen 2 aus einem anorganischen Glas, beispielsweise Boratglas. Das Plättchen ist beispielsweise 200 µm dick. In dem Plättchen sind erste Konverterpartikel 3 angeordnet, die einen Durchmesser von 30 µm aufweisen. Abweichungen des Durchmessers um bis zu 10 % sind möglich. Die ersten Konverterpartikel 3 sind vollständig in das anorganische Glas des Plättchens 2 eingebettet und stehen mit diesem in direktem mechanischen Kontakt. Die ersten Konverterpartikel 3 bestehen aus einem Kern 3b und einer Hülle 3a. Der Kern 3b besteht aus einem nitridischen Leuchtstoff der Formel M₂SiN₈:Eu²⁺ mit M = Ca, Sr, Ba oder Mischungen daraus und emittiert Licht im roten Wellenlängenbereich des elektromagnetischen Spektrums. Die Hülle 3a besteht beispielsweise aus SiO₂. Wie in Figur 1a gezeigt, weist das Plättchen 2 eine erste Hauptoberfläche 2a und eine zweite Hauptoberfläche 2b auf. Die erste Hauptoberfläche 2a weist einen kleineren Abstand zu den ersten Konverterpartikeln 3 als die zweite Hauptoberfläche 2b auf. Dies resultiert aus der Herstellung des Konversionselements 1 bei der in einer Ausführungsform nur eine Oberflächenschicht der ersten Hauptoberfläche 2a des Plättchens 2 angeschmolzen wird, die ersten Konverterpartikel 3 aufgebracht werden und einsinken. Durch das Aufbringen der ersten Konverterpartikel 3 auf die angeschmolzene Oberflächenschicht der ersten Hauptoberfläche 2a des Plättchens 2 wird die Hülle 3a der ersten Konverterpartikel 3 angeschmolzen. Dadurch entstehen zwischen dem anorganischen Glas und dem Material der Hülle 3a kovalente und/oder ionische Bindungen, wodurch die ersten Konverterpartikel 3 fest in dem Plättchen 2 ein- und angebunden sind. Über der zweiten Hauptoberfläche kann eine reflektive und/oder antireflektive Schicht angeordnet sein (hier nicht gezeigt).

Das Konversionselement 1 gemäß Figur 1b zeigt im Vergleich zu dem Konversionselement 1 der Figur 1a zusätzlich zweite Konverterpartikel 7, die in dem Plättchen 2 angeordnet sind und vollständig in das anorganischen Glas des Plättchens 2 eingebettet sind. Die zweiten Konverterpartikel 7 bestehen aus einem oxidischen Leuchtstoff, beispielsweise aus LuAG. Das Konversionselement 1 gemäß diesem Ausführungsbeispiel wird hergestellt, indem zunächst die zweiten Konverterpartikel 7 auf eine angeschmolzene Oberflächenschicht der ersten Hauptoberfläche 2a des Plättchens 2 aufgebracht werden, man diese einsinken lässt und anschließend die ersten Konverterpartikel 3 auf die abgeschmolzene Oberflächenschicht der ersten Hauptoberfläche 2a des Plättchens 2 aufgebracht werden und diese einsinken.

Das Konversionselement 1 gemäß Figur 2a zeigt ein Plättchen 2 aus einem anorganischen Glas, beispielsweise Quarzglas. Das Plättchen 2 ist beispielsweise 200 µm dick. Auf dem Plättchen 2 sind erste Konverterpartikel 3 angeordnet. Die ersten Konverterpartikel 3 bestehen aus einem Kern 3b und einer Hülle 3a. Der Kern 3b besteht aus einem nitridischen Leuchtstoff der Formel M₂SiN₈:Eu²⁺ mit M = Ca, Sr, Ba oder Mischungen daraus und emittiert Licht im roten Wellenlängenbereich des elektromagnetischen Spektrums. Die Hülle 3a besteht beispielsweise aus AlN. Bei dem Aufbringen der ersten Konverterpartikel 3 auf die angeschmolzene Oberflächenschicht der ersten Hauptoberfläche 2a des Plättchens 2 sind die ersten Konverterpartikel 3 nicht eingesunken. Es ist möglich, dass einige erste Konverterpartikel 3 teilweise in die angeschmolzene Oberflächenschicht einsinken, so dass diese teilweise in das Plättchen 2 eingebettet sind. Es sind zweite Konverterpartikel 7 in dem Plättchen 2 angeordnet und vollständig in das anorganische Glas eingebettet. Die zweiten Konverterpartikel 7 bestehen aus einem oxidischen Leuchtstoff, beispielsweise aus YAG. Auf der ersten Hauptoberfläche 2a des Plättchens 2 ist eine Schutzschicht 4 angeordnet. Die Schutzschicht 4 besteht beispielsweise aus Parylen. Die Schutzschicht 4 ist beispielsweise 40 µm dick. Sie bedeckt die ersten Konverterpartikel 3 vollständig, so dass die ersten Konverterpartikel in direktem mechanischen Kontakt zu dem anorganischen Material des Plättchens 2 und/oder der Schutzschicht 4 stehen. Die ersten Konverterpartikel 3 weisen somit keinen Kontakt zur Umgebungsluft auf. Alternativ können auch keine zweiten Konverterpartikel 7 in dem Konversionselement 1 vorhanden sein.

Das Konversionselement 1 gemäß Figur 2b zeigt im Vergleich zu dem Konversionselement in Figur 2a, dass die ersten Konverterpartikel 3 teilweise in das anorganische Glas des Plättchens 2 eingebettet sind. Die ersten Konverterpartikel 3 sind während des Herstellungsverfahrens also teilweise in die angeschmolzene Oberflächenschicht der ersten Hauptoberfläche 2a des Plättchens 2 eingesunken. Alternativ können auch keine zweiten Konverterpartikel 7 in dem Konversionselement 2 vorhanden sein.

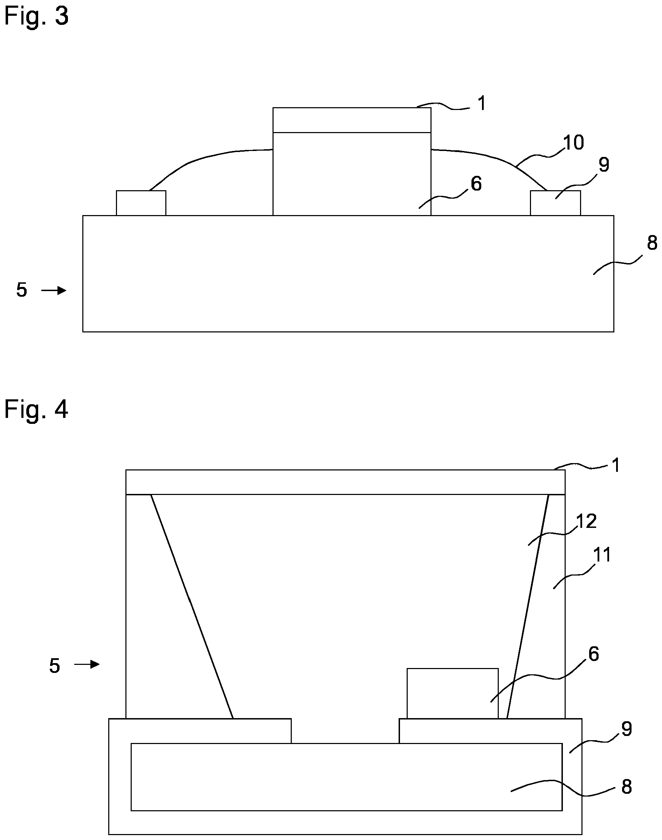

Das optoelektronische Bauelement 5 gemäß Figur 3 zeigt einen Träger 8 mit einem Leiterrahmen 9. Auf dem Träger 8 ist eine Schichtenfolge 6 angeordnet, die mit dem Leiterrahmen 9 über Bonddrähte 10 elektrisch verbunden ist. Über der Schichtenfolge 6 ist ein Konversionselement 1 angebracht. Das Konversionselement 1 entspricht einem Konversionselement 1, das in den Figuren 1a, 1b, 2a oder 2b dargestellt ist. Das Konversionselement 1 aus den Figuren 1a bis 2b kann so angeordnet werden, dass die erste 2a oder zweite Hauptoberfläche 2b des Plättchens 2 der Schichtenfolge 6 zugewandt ist. Bevorzugt ist bei Konversionselementen 1 gemäß der Figuren 2a und 2b die zweite Hauptoberfläche 2b der Schichtenfolge 6 zugewandt. Weist das Konversionselement 1 der Figur 1a bis 2b eine antireflektive und/oder reflektive Schicht auf (nicht gezeigt) wird das Konversionselement 1 so angeordnet, dass die zweite Hauptoberfläche 2b des Plättchens 2 der Schichtenfolge 6 zugewandt ist. Das Konversionselement 1 ist in dem Strahlengang der elektromagnetischen Primärstrahlung angeordnet, die von einer aktiven Schicht (hier nicht separat dargestellt) in der Schichtenfolge 6 emittiert wird. Das Konversionselement 1 ist stabil gegen Temperatur-, Feuchte und Strahlenbelastungen. Es trübt nicht oder nur geringfügig ein und vergilbt nicht oder nur geringfügig. Damit ist gewährleistet, dass die Lichtausbeute nicht oder wenig herabgesetzt wird und die Abstrahlcharakteristik des optoelektronischen Bauelements 5 nicht oder nur geringfügig verändert wird. Eine antireflektive und/oder reflektive Schicht kann eine Bandpass- oder Kantenfiltercharakteristik aufweisen und für die Primärstrahlung durchlässig (antireflektiv) und für die Sekundärstrahlung reflektiv sein.

Zusätzlich kann zwischen der Schichtenfolge 6 und dem Konversionselement 1 eine Haftschicht (hier nicht gezeigt) angebracht sein. Die Haftschicht kann beispielsweise Silikon umfassen.

Vorzugsweise handelt es sich bei dem optoelektronischen Bauelement 5 um eine LED, wobei die Strahlung in der Figur nach oben über eine transparente Schichtenfolge 6 und das Konversionselement 1, ausgekoppelt wird.

Das optoelektronische Bauelement 5 gemäß Figur 4 zeigt einen Träger 8 mit einem Leiterrahmen 9 und ein Gehäuse 11. Das Gehäuse 11 weist in der Mitte eine Ausnehmung auf, in der die Schichtenfolge 6 angeordnet ist, die mit dem Leiterrahmen 9 elektrisch leitend verbunden ist. Die Ausnehmung ist mit einem Verguss 12 ausgefüllt. Der Verguss 12 umfasst beispielsweise ein Sikikon oder Epoxid.

Über der Ausnehmung des Gehäuses 11 und dem Gehäuse 11 ist ein Konversionselement 1 angeordnet. Das Konversionselement 1 ist in dem Strahlengang der elektromagnetischen Primärstrahlung angeordnet, die von einer aktiven Schicht (hier nicht separat dargestellt) in der Schichtenfolge 6 emittiert wird.

Das Konversionselement 1 entspricht einem Konversionselement 1, das in den Figuren 1a, 1b, 2a oder 2b dargestellt ist.

Zusätzlich kann zwischen dem Gehäuse 11 und dem Konversionselement 1 und zwischen dem Verguss 12 und dem Konversionselement 1 eine Haftschicht (hier nicht gezeigt) angebracht sein. Die Haftschicht kann beispielsweise Silikon umfassen.

Vorzugsweise handelt es sich bei dem optoelektronischen Bauelement 1 um eine LED, wobei die Strahlung in der Figur nach oben über eine transparente Schichtenfolge 6, einen transparenten Verguss 12 und das Konversionselement 1 ausgekoppelt wird.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

Diese Patentanmeldung beansprucht die Prioritäten der deutschen Patentanmeldungen 10 2014 102 848.1 und 10 2013 114 548.5.

## Patentansprüche

1. Konversionselement (1)
- mit einem Plättchen (2) umfassend ein anorganisches Glas,
- mit ersten Konverterpartikeln (3), wobei
- die ersten Konverterpartikel (3) auf und/oder in dem Plättchen (2) angeordnet sind,
**dadurch gekennzeichnet dass**,
- die ersten Konverterpartikel (3) eine Hülle (3a) und einen Kern (3b) aufweisen,
- die Hülle (3a) ein anorganisches Material umfasst und eine Dicke zwischen wenigstens 10 nm und höchstens 50 µm aufweist,
- der Kern (3b) einen nitridischen oder oxynitridischen Leuchtstoff umfasst und
- die ersten Konverterpartikel (3) einen Durchmesser von wenigstens 10 µm bis höchstens 100 µm aufweisen.

2. Konversionselement (1) nach dem vorherigen Anspruch, wobei zwischen dem anorganischen Material der Hülle (3a) der ersten Konverterpartikel (3) und einem anorganischen Glas des Plättchens (2) eine chemische Bindung besteht.

3. Konversionselement (1) nach einem der vorherigen Ansprüche, bei dem das anorganische Material der Hülle (3a) aus einer Gruppe ausgewählt ist, die SiO₂, TiO, TiO₂, Al₂O₃, B₂O₃, ZrO, ZrO₂, ZnO, ZnO₂, ein anorganisch-organisches Hybridmaterial, AlN, BN, TiN, Si₃N₄, ZrN, Zn₃N₂, Graphen und Kombinationen daraus umfasst.

4. Konversionselement (1) nach einem der vorhergehenden Ansprüche, bei dem über dem Plättchen (2) eine Schutzschicht (4) angeordnet ist, die ein Material umfasst, das aus einer Gruppe ausgewählt ist, die Parylen, Polysilazan, Silikon, SiO₂, TiO, TiO₂, Al₂O₃, B₂O₃, ZrO, ZrO₂, ZnO, ZnO₂, ein anorganisch-organisches Hybridmaterial, AlN, BN, TiN, Si₃N₄, ZrN, Zn₃N₂, Graphen, ein anorganisches Glas und Kombinationen daraus umfasst.

5. Konversionselement (1) nach einem der vorhergehenden Ansprüche, bei dem die ersten Konverterpartikel (3) vollständig in das anorganische Glas des Plättchens (2) oder vollständig in das anorganische Glas des Plättchens (2) und das Material der Schutzschicht (4) eingebettet sind.

6. Konversionselement (1) nach einem der vorhergehenden Ansprüche, das zweite Konverterpartikel (7) umfasst, die einen oxidischen Leuchtstoff umfassen.

7. Konversionselement (1) nach einem der vorhergehenden Ansprüche, bei dem die zweiten Konverterpartikel auf und/oder in dem Plättchen (2) angeordnet sind.

8. Konversionselement (1) nach zumindest Anspruch 2, wobei es sich bei der chemischen Bindung um eine kovalente Bindung handelt.

9. Konversionselement (1) nach einem der vorhergehenden Ansprüche, bei dem das anorganische Glas ein Silikatglas, ein Boratglas oder ein Phosphatglas ist.

10. Verfahren zur Herstellung eines Konversionselements (1) nach einem der vorhergehenden Ansprüche, umfassend den Verfahrensschritt
A) Beschichtung von Partikeln eines nitridischen oder oxynitridischen Leuchtstoffs mit einem anorganischen Material, das aus einer Gruppe ausgewählt ist, die SiO₂, TiO, TiO₂, Al₂O₃, B₂O₃, ZrO, ZrO₂, ZnO, ZnO₂, ein anorganisch-organisches Hybridmaterial, AlN, BN, TiN, Si₃N₄, ZrN, Zn₃N₂, Graphen und Kombinationen daraus umfasst zur Bildung von ersten Konverterpartikeln (3), die eine Hülle (3a) aus dem anorganischen Material und einen Kern (3b) aus dem nitridischen oder oxynitridischen Leuchtstoff aufweisen.

11. Verfahren nach dem vorhergehenden Anspruch, umfassend die weiteren Schritte:
B) Bereitstellen eines Plättchens (2) bestehend aus Glas,
C) Anschmelzen einer Oberflächenschicht des Plättchens (2), und
E) Aufbringen der ersten Konverterpartikel (3) auf die angeschmolzene Oberflächenschicht.

12. Verfahren nach Anspruch 10, umfassend die weiteren Schritte, in der angegebenen Reihenfolge:
B) Erzeugen einer Glasfritte oder eines Pulvers aus einem anorganischen Glas,
C) Mischen der Glasfritte oder des Pulvers mit den ersten Konverterpartikeln (3) und einem flüssigen Dispersionsmittel, sodass eine Grundformmasse entsteht,
D) Gießen der Grundformmasse zu einem Konversionselementerohkörper oder zu den Plättchen (2), wobei das Dispersionsmittel vollständig oder nur zum Teil verdampft, und
G) Sintern der Plättchen (2) oder des Konversionselementerohkörpers, sodass sich das anorganische Glas mit den ersten Konverterpartikeln (3) fest und dauerhaft verbindet.

13. Verfahren nach dem vorhergehenden Anspruch, umfassend die zusätzlichen Schritte, die entsprechend der angegebenen Aufzählung von A nach H durchgeführt werden:E) Zerteilen des Konversionselementerohkörpers zu den Konversionselementen, wobei im Schritt D) der Konversionselementerohkörper geformt wird,F) Entfernen eines Binders, der der Grundformmasse im Schritt C) beigegeben wurde, sodass ausschließlich das anorganische Glas und die Konverterpartikel in der Grundformmasse verbleiben, undH) Formen zu den Konversionselementen (1) und zu den Plättchen (2) aus dem Konversionselementerohkörper.

14. Verfahren nach Anspruch 11, wobei beim Aufbringen der ersten Konverterpartikel (3) auf die angeschmolzene Oberflächenschicht in Verfahrensschritt E) die Hülle (3a) der ersten Konverterpartikel (3) mit der angeschmolzenen Oberflächenschicht in Kontakt kommt und angeschmolzen wird.

15. Verfahren nach einem der Ansprüche 11 oder 14, wobei nach Verfahrensschritt E) ein weiterer Verfahrensschritt stattfindet:
F) Teilweises und/oder vollständiges Einsinkenlassen der ersten Konverterpartikel (3) in die angeschmolzene Oberflächenschicht.

16. Verfahren nach einem der Ansprüche 11, 14 oder 15, wobei nach Verfahrensschritt C) zwei weitere Verfahrensschritte stattfinden:
D) Aufbringen von zweiten Konverterpartikeln (7), die einen oxidischen Leuchtstoff umfassen auf die angeschmolzene Oberflächenschicht,
D1) vollständiges Einsinkenlassen der zweiten Konverterpartikel (7) in die angeschmolzene Oberflächenschicht.

17. Verfahren nach einem der Ansprüche 10 bis 16, wobei zur Beschichtung der Partikel des nitridischen oder oxynitridischen Leuchtstoffs in Verfahrensschritt A) ein Schlicker oder ein Gel umfassend das anorganische Material oder das anorganische Material in einem gasförmigen Aggregatszustand eingesetzt wird.

18. Optoelektronisches Bauelement (5) umfassend
- eine Schichtenfolge (6) mit einer aktiven Schicht, die im Betrieb des Bauelements elektromagnetische Primärstrahlung emittiert,
- zumindest ein Konversionselement (1) nach einem der Ansprüche 1 bis 9, das im Strahlengang der elektromagnetischen Primärstrahlung und über der Schichtenfolge (6) angeordnet ist, wobei
- die ersten Konverterpartikel (3) zumindest teilweise die elektromagnetische Primärstrahlung in eine elektromagnetische Sekundärstrahlung konvertieren.

## Claims

1. Conversion element (1)
- with a platelet (2) comprising an inorganic glass,
- with first converter particles (3), wherein
- the first converter particles (3) are arranged on and/or in the platelet (2),
**characterized in that**,
- the first converter particles (3) have a shell (3a) and a core (3b),
- the shell (3a) comprises an inorganic material and has a thickness between at least 10 nm and at most 50 µm,
- the core (3b) comprises a nitrid or oxynitrid phosphor and
- the first converter particles (3) have a diameter of at least 10 µm to at most 100 µm.

2. Conversion element (1) according to the preceding claim,
wherein a chemical bond exists between the inorganic material of the shell (3a) of the first converter particles (3) and an inorganic glass of the platelet (2) .

3. Conversion element (1) according to any of the preceding claims, wherein the inorganic material of the shell (3a) is selected from a group comprising SiO₂, TiO, TiO₂, Al₂O₃, B₂O₃, ZrO, ZrO₂, ZnO, ZnO₂, an inorganic-organic hybrid material, AlN, BN, TiN, Si₃N₄, ZrN, Zn₃N₂, graphene and combinations thereof.

4. A conversion element (1) according to any of the preceding claims, wherein a protective layer (4) comprising a material selected from a group consisting of parylene, polysilazane, silicone, SiO₂, TiO, TiO₂, Al₂O₃, B₂O₃, ZrO, ZrO₂, ZnO, ZnO₂, an inorganic-organic hybrid material, AlN, BN, TiN, Si₃N₄, ZrN, Zn₃N₂, graphene, an inorganic glass and combinations thereof.

5. Conversion element (1) according to any of the preceding claims, wherein the first converter particles (3) are completely embedded in the inorganic glass of the platelet (2) or completely embedded in the inorganic glass of the platelet (2) and the material of the protective layer (4).

6. Conversion element (1) according to any of the preceding claims, comprising second converter particles (7) comprising an oxide phosphor.

7. Conversion element (1) according to any of the preceding claims, in which the second converter particles are arranged on and/or in the platelet (2).

8. Conversion element (1) according to at least claim 2, wherein the chemical bond is a covalent bond.

9. Conversion element (1) according to any of the preceding claims, wherein the inorganic glass is a silicate glass, a borate glass or a phosphate glass.

10. A process for producing a conversion element (1) according to any of the preceding claims, comprising the step of
A) coating particles of a nitride or oxynitride phosphor with an inorganic material selected from a group consisting of SiO₂, TiO, TiO₂, Al₂O₃, B₂O₃, ZrO, ZrO₂, ZnO, ZnO₂, an inorganic-organic hybrid material, AlN, BN, TiN, Si₃N₄, ZrN, Zn₃N₂, graphene and combinations thereof to form first converter particles (3) having a shell (3a) of the inorganic material and a core (3b) of the nitride or oxynitride phosphor.

11. The process according to the preceding claim, comprising the further steps:
B) providing a platelet (2) made of glass,
C) melting a surface layer of the platelet (2), and
E) applying the first converter particles (3) to the melted surface layer.

12. The process according to claim 10, comprising the further steps, in the order given:
B) producing a glass frit or a powder of an inorganic glass,
C) mixing the glass frit or powder with the first converter particles (3) and a liquid dispersant to form a basic molding compound,
D) casting the basic molding compound to form a conversion element blank or to the platelets (2), the dispersion agent evaporating completely or only partially, and
G) sintering of the platelets (2) or the conversion element blank so that the inorganic glass bonds firmly and permanently with the first converter particles (3).

13. The process according to the preceding claim, comprising the additional steps carried out from A) to H) according to the indicated enumeration: E) dividing the conversion element blank into the conversion elements, wherein in step D) the conversion element blank is formed, F) removing a binder which was added to the basic molding compound in step C) so that only the inorganic glass and the converter particles remain in the basic molding compound, and H) forming to the conversion elements (1) and into platelets (2) from the conversion element blank.

14. The process according to claim 11, wherein when the first converter particles (3) are applied to the fused surface layer in method step E), the shell (3a) of the first converter particles (3) comes into contact with the melted surface layer and is melted.

15. The process according to any of claims 11 or 14, wherein a further method step takes place after method step E):
F) partial and/or complete sinking of the first converter particles (3) into the melted surface layer.

16. The process according to any of claims 11, 14 or 15, wherein two further process steps take place after process step C):
D) applying second converter particles (7), which comprise an oxide phosphor, to the melted surface layer, D1) complete sinking of the second converter particles (7) into the melted surface layer.

17. The process according to any one of claims 10 to 16, wherein a slip or a gel comprising the inorganic material or the inorganic material in a gaseous aggregate state is used for coating the particles of the nitride or oxynitride phosphor in process step A).

18. Optoelectronic component (5) comprising
- a layer sequence (6) with an active layer which emits primary electromagnetic radiation during operation of the component,
- at least one conversion element (1) according to one of claims 1 to 9, which is arranged in the beam path of the electromagnetic primary radiation and above the layer sequence (6), wherein
- the first converter particles (3) at least partially convert the primary electromagnetic radiation into secondary electromagnetic radiation.

## Revendications

1. Élément de conversion (1)
- avec une plaquette (2) comprenant un verre inorganique,
- avec des premières particules de convertisseur (3),
- les premières particules de convertisseur (3) étant disposées sur et/ou dans la plaquette (2),
**caractérisé en ce que**
- les premières particules de convertisseur (3) présentent une enveloppe (3a) et un noyau (3b),
- l'enveloppe (3a) comprend un matériau inorganique et présente une épaisseur comprise entre au moins 10 nm et au plus 50 µm,
- le noyau (3b) comprend une substance luminescente à base de nitrure ou d'oxynitrure et
- les premières particules du convertisseur (3) présentent un diamètre compris entre au moins 10 µm et au plus 100 µm.

2. Élément de conversion (1) selon la revendication précédente,
dans lequel une liaison chimique existe entre le matériau inorganique de l'enveloppe (3a) des premières particules de convertisseur (3) et un verre inorganique de la plaquette (2).

3. Elément de conversion (1) selon l'une des revendications précédentes, dans lequel le matériau inorganique de l'enveloppe (3a) est choisi dans un groupe comprenant du SiO₂, du TiO, du TiO₂, de l'Al₂O₃, du B₂O₃, du ZrO, du ZrO₂, du ZnO, du ZnO₂, un matériau hybride inorganique-organique, de l'AlN, du BN, du TiN, du Si₃N₄, du ZrN, du Zn₃N₂, du graphène et des combinaisons de ceux-ci.

4. Elément de conversion (1) selon l'une des revendications précédentes, dans lequel une couche protectrice (4), contenant un matériau choisi parmi un groupe de matériaux comprenant du parylène, du polysilazane, du silicone, du SiO₂, du TiO, du TiO₂, de l'Al₂O₃, du B₂O₃, du ZrO, du ZrO₂, du ZnO, du ZnO₂, un matériau hybride inorganique-organique, de l'AlN, du BN, du TiN, du Si₃N₄, du ZrN, du Zn₃N₂, du graphène, un verre inorganique et des combinaisons de ceux-ci, est disposée sur la plaquette (2).

5. Elément de conversion (1) selon l'une des revendications précédentes, dans lequel les premières particules de convertisseur (3) sont complètement incorporées au verre inorganique de la plaquette (2) ou complètement incorporées au verre inorganique de la plaquette (2) et au matériau de la couche protectrice (4).

6. Élément de conversion (1) selon l'une des revendications précédentes, comprenant des secondes particules de convertisseur (7) dotées d'une substance luminescente à base d'oxyde.

7. Elément de conversion (1) selon l'une des revendications précédentes, dans lequel les secondes particules de conversion sont disposées sur et/ou dans la plaquette (2) .

8. Élément de conversion (1) selon au moins la revendication 2,
dans lequel la liaison chimique est une liaison covalente.

9. Élément de conversion (1) selon l'une des revendications précédentes, dans lequel le verre inorganique est un verre de silicate, un verre de borate ou un verre de phosphate.

10. Procédé de fabrication d'un élément de conversion (1) selon l'une des revendications précédentes, comprenant l'étape
A) Enrobage de particules d'une substance luminescente à base de nitrure ou d'oxynitrure avec un matériau inorganique choisi dans un groupe comprenant du SiO₂, du TiO, du TiO₂, de l'Al₂O₃, du B₂O₃, du ZrO, du ZrO₂, du ZnO, du ZnO₂, un matériau hybride inorganique-organique, de l'AlN, du BN, du TiN, du Si₃N₄, du ZrN, du Zn₃N₂, du graphène et des combinaisons de ceux-ci pour former des premières particules de convertisseur (3) présentant une enveloppe (3a) faite de la matière inorganique et un noyau (3b) formé de la substance luminescente à base de nitrure ou d'oxynitrure.

11. Procédé selon la revendication précédente, comprenant les étapes suivantes :
B) Mise à disposition d'une plaquette (2) en verre,
C) Fusion d'une couche de surface de la plaquette (2), et
E) Application des premières particules de convertisseur (3) sur la couche de la surface fondue.

12. Procédé selon la revendication 10, comprenant les étapes supplémentaires dans l'ordre indiqué :
B) Production d'une fritte de verre ou d'une poudre à partir d'un verre inorganique,
C) Mélange de la fritte de verre ou de la poudre avec les premières particules de convertisseur (3) et un dispersant liquide de manière à former une masse de moulage de base,
D) Coulage de la masse de moulage de base afin de former une ébauche d'élément de conversion ou pour les plaquettes (2), le dispersant s'évaporant entièrement ou seulement partiellement, et
G) Frittage des plaquettes (2) ou de l'ébauche de l'élément de conversion de manière à ce que le verre inorganique se lie fermement et de façon permanente aux premières particules de convertisseur (3).

13. Procédé selon la revendication précédente, comprenant les étapes supplémentaires effectuées de A à H conformément à la liste indiquée: E) Division de l'ébauche d'élément de conversion en éléments de conversion, l'ébauche d'élément de conversion étant formée à l'étape D), F) Élimination d'un liant ajouté à la masse de moulage de base à l'étape C), de sorte que seuls le verre inorganique et les particules de convertisseur restent dans la masse de moulage de base, et H) Moulage des éléments de conversion (1) et des plaquettes (2) à partir de l'ébauche d'élément de conversion.

14. Procédé selon la revendication 11, dans lequel, lorsque les premières particules de convertisseur (3) sont appliquées sur la couche de surface fondue à l'étape E), l'enveloppe (3a) des premières particules de convertisseur (3) entre en contact avec la couche de surface fondue et est fondue.

15. Procédé selon l'une des revendications 11 ou 14, dans lequel une étape supplémentaire a lieu après l'étape E) :
F) Enfoncement partiel et/ou complet des premières particules de convertisseur (3) dans la couche de surface fondue.

16. Procédé selon l'une des revendications 11, 14 ou 15, dans lequel deux étapes supplémentaires ont lieu après l'étape C) :
D) Application de secondes particules de convertisseur (7) comprenant un oxyde de substance luminescente sur la couche de surface fondue,
D1) Enfoncement complet des secondes particules de convertisseur (7) dans la couche de surface fondue.

17. Procédé selon l'une des revendications 10 à 16, dans lequel une barbotine ou un gel comprenant la matière inorganique ou la matière inorganique à l'état d'agrégat gazeux est utilisé pour enrober les particules de la substance luminescente à base de nitrure ou d'oxynitrure à l'étape A).

18. Composant optoélectronique (5) comprenant :
- une succession de couches (6) dotée d'une couche active émettant un rayonnement électromagnétique primaire durant le fonctionnement du composant,
- au moins un élément de conversion (1) selon l'une des revendications 1 à 9, disposé sur la trajectoire du rayonnement électromagnétique primaire et au-dessus de la succession de couches (6),
- les premières particules de convertisseur (3) convertissant au moins partiellement le rayonnement électromagnétique primaire en un rayonnement électromagnétique secondaire.
